# EUROPEAN PATENT APPLICATION

(11) **EP 1 643 561 A2**
(43) Date of publication of application: **05.04.2006**
(21) Application number: 05108787.2
(22) Date of filing: 23.09.2005
(51) Int. Cl.: H01L 29/872, H01L 29/739, H01L 29/47

(54) **GaN-based semiconductor integrated circuit**

(30) Priority: 30.09.2004 JP 2004286124
(71) Applicant: FURUKAWA ELECTRIC CO., LTD., Tokyo 100-8322 (JP)
(72) Inventor: Yoshida, Seikoh, The Furukawa Electric Co., Ltd., Chiyoda-ku, Tokyo 100-8322 (JP)
(74) Representative: Modiano, Micaela Nadia

(57) **Abstract**

A GaN-based semiconductor integrated circuit comprising a plurality of types of GaN-based semiconductor devices integrated on a single substrate, and one of the plurality of types of GaN-based semiconductor devices includes a Schottky diode. The Schottky diode includes a GaN-based semiconductor layer, a first anode and a second anode, wherein the first anode is joined to the GaN-based semiconductor layer to form a Schottky junction with a width smaller than the width of the GaN-based semiconductor layer, the second anode is joined to the GaN-based semiconductor layer to form a Schottky junction in a region other than the region in which the first anode is in contact with the GaN-based semiconductor layer, and electrically connected with the first anode, and the Schottky barrier formed between the second anode and the GaN-based semiconductor layer is higher than the Schottky barrier formed between the second anode and the GaN-based semiconductor layer.

## Description

### BACKGROUND OF THE INVENTION

### Field of the Invention

This invention relates to a semiconductor integrated circuit comprising a plurality of types of GaN-based semiconductor devices integrated on a substrate, and in particular, a GaN-based semiconductor integrated circuit suited to be used for large power conversion.

### Description of the Related Art

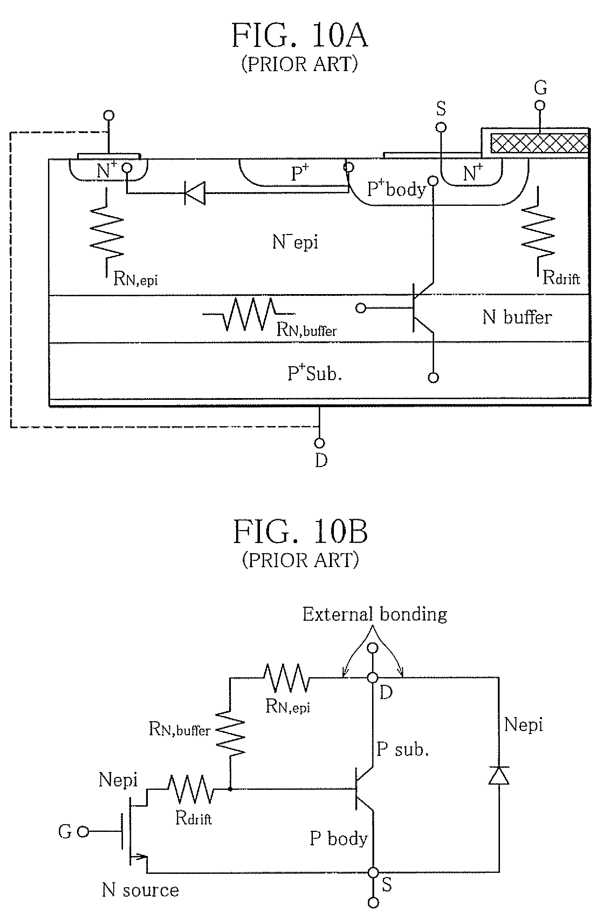

A power conversion device such as an inverter or a converter used in a power module for power conversion is formed using a semiconductor integrated circuit. Such power conversion device has a device structure shown in FIG. 10A, for example. As seen in FIG. 10B which shows the equivalent circuit thereof, the power conversion device is formed as an integrated circuit including a combination of an IGBT (insulated gate bipolar transistor) and a diode, each mainly made from Si-based semiconductors. The semiconductor integrated circuit including a combination of an IGBT and a diode is described in detail in "Design of IGBT with Integral Freewheeling Diode", Ettore Napoli et al., IEEE ELECTRON DEVICE LETTERS, Vol. 23, No. 9, September 2002.

Using, in a power module, a semiconductor integrated circuit of a device structure shown in FIG. 10A including Si-based semiconductor devices has, however, the following problem: In the power module, since a principal current flowing through the integrated circuit is larger than several hundred A, a voltage applied across the p-n junction of an Si-based semiconductor device is 3V or higher. Accordingly, a large amount of heat is generated corresponding to the energy loss under the voltage applied across the p-n junction, so that a large cooling device is required to cool the semiconductor integrated circuit.

Besides, the IGBT and diode formed as Si-based semiconductor devices need to have a large transverse cross-sectional area relative to the direction of flow of a current, in order to have an adequately high withstand voltage. Hence, the area of the region where heat is generated (p-n junction) is large, so that the cooling device needs to be correspondingly large.

### SUMMARY OF THE INVENTION

An object of this invention is to provide a semiconductor integrated circuit which is suited for large power convention and which can be formed with a reduced size and does not generate a large amount of heat.

The invention provides a GaN-based semiconductor integrated circuit comprising a plurality of types of GaN-based semiconductor devices integrated on a substrate, wherein a Schottky diode is included as one of the GaN-based semiconductor devices. The Schottky diode includes a GaN-based semiconductor layer, a first anode and a second anode, wherein the first anode is joined to the GaN-based semiconductor layer to form a Schottky junction with a width smaller than the width of the GaN-based semiconductor layer, the second anode is joined to the GaN-based semiconductor layer to form a Schottky junction in a region other than the region in which the first anode is in contact with the GaN-based semiconductor layer, and electrically connected with the first anode, and the Schottky barrier formed between the second anode and the GaN-based semiconductor layer is higher than the Schottky barrier formed between the first anode and the GaN-based semiconductor layer.

The height of the Schottky barrier between the first anode and the GaN-based semiconductor layer and the height of the Schottky barrier between the second anode and the GaN-based semiconductor layer are set separately, by using different materials (metals) for the first and second anodes. For example, for the first anode, Ti (titanium), W (tungsten) or Ag (silver) is used, and for the second anode, Pt (platinum), Ni (nickle), Pd (palladium) or Au (gold) is used. Preferably, the second anode is arranged to cover the first anode.

In a desirable arrangement, the aforesaid plurality of types of GaN-based semiconductor devices include at least one of an FET (field effect transistor), an IGBT, a GTO (gate turn-off thyristor) and a thyristor, as a GaN-based semiconductor device other than the Schottky diode.

In a desirable arrangement, the aforesaid plurality of types of GaN-based semiconductor devices include the aforesaid Schottky diode and an FET, wherein the FET has a device structure including a layer structure formed of almost the same semiconductor materials as the semiconductor materials forming the layer structure included in the device structure of the Schottky diode.

In a desirable arrangement, a semiconductor device other than a GaN-based semiconductor device is integrated with the aforesaid plurality of types of GaN-based semiconductor devices, on the substrate.

The present invention also provides a power conversion device incorporating the aforesaid GaN-based semiconductor integrated circuit.

The Schottky diode included in the aforesaid GaN-based semiconductor integrated circuit has a composite anode consisting of a first anode and a second anode. Since the Schottky barrier formed between the first anode and the GaN-based semiconductor layer is lower than the Schottky barrier formed between the second anode and the GaN-based semiconductor layer, the on-state voltage required to give rise to a forward current when the Schottky diode is forward biased is a low voltage, depending only on the height of the Schottky barrier formed between the first anode and the GaN-based semiconductor layer. Consequently, the energy loss in the junction region reduces, and hence, the amount of heat generated corresponding to the energy loss can be kept small. Further, a reverse leak current produced when the Schottky diode is reverse biased is blocked by the Schottky barrier formed between the second anode and the GaN-based semiconductor layer, so that the Schottky diode has an adequately high withstand voltage.

Thus, the present invention can provide a semiconductor integrated circuit which does not generate a large amount of heat and has a high withstand voltage. Further, compared with the Si-based semiconductor device, the GaN-based semiconductor device can be formed with a smaller size and operate at higher speed. Hence, in the GaN-based semiconductor device, the amount of heat generated can be reduced by making the transverse cross-sectional area relative to the direction of flow of a current smaller. Thus, a semiconductor integrated circuit of a small size suited for large power conversion can be formed easily.

### BRIEF DESCRIPTION OF THE DRAWINGS

The present invention will become more fully understood from the detailed description given hereinbelow and the accompanying drawings which are given by way of illustration only, and thus, are not limitative of the present invention, and wherein:
FIG. 1 is a plan view showing a schematic structure of a GaN-based semiconductor integrated circuit in an embodiment of this invention,
FIG. 2 is a cross-sectional view showing the device structure of the GaN-based semiconductor integrated circuit shown in FIG. 1,
FIG. 3A is a diagram showing a device structure in the first stage in the process of producing the GaN-based semiconductor integrated circuit shown in FIG. 1,
FIG. 3B is a diagram showing a device structure in the second stage subsequent to FIG. 3A,
FIG. 3C is a diagram showing a device structure in the third stage subsequent to FIG. 3B,
FIG. 3D is a diagram showing a device structure in the fourth stage subsequent to FIG. 3C,
FIG. 3E is a diagram showing a device structure in the fifth stage subsequent to FIG. 3D,
FIG. 3F is a diagram showing a device structure in the sixth stage subsequent to FIG. 3E,
FIG. 3G is a diagram showing a device structure in the seventh stage subsequent to FIG. 3F,
FIG. 4 is a diagram showing an example of a power conversion device using an GaN-based semiconductor integrated circuit according to this invention,
FIG. 5 is a cross-sectional view showing a device structure of a GaN-based FET,
FIG. 6 is a cross-sectional view showing a device structure of a GaN-based Schottky diode,
FIG. 7 is a cross-sectional view showing a device structure of an Si-based IGBT,
FIG. 8 is a cross-sectional view showing a device structure of an Si-based FET,
FIG. 9 is a cross-sectional view showing a device structure of a semiconductor integrated circuit in another embodiment of this invention, in which semiconductor devices shown in FIGS. 5 to 8 are integrated,
FIG. 10A is a cross-sectional view showing a device structure of a conventional semiconductor integrated circuit, and
FIG. 10B shows the equivalent circuit of the semiconductor integrated circuit shown in FIG. 10A.

### DETAILED DESCRIPTION OF THE PREFERRED EMBODIMENTS

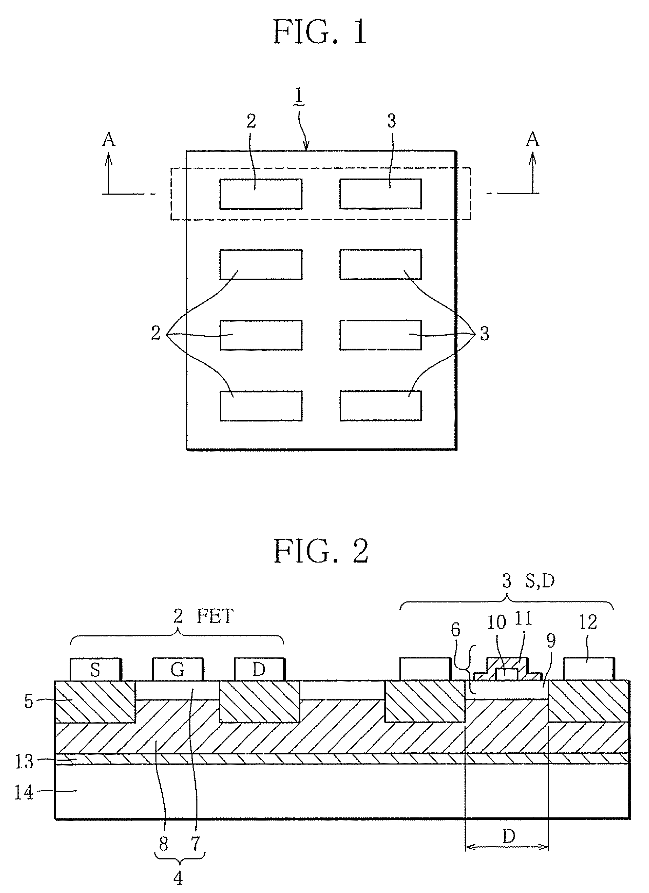

The GaN-based semiconductor integrated circuit according to the present invention is suited to be used mainly for a power conversion device such as an inverter or a converter. It is formed, for example, as a GaN-based semiconductor integrated circuit 1 shown in FIG. 1 in which two semiconductor devices of different types, namely one FET 2 and one Schottky diode 3 form one unit (part surrounded by the dotted line in FIG. 1), and in which four of such units are integrated. In this example, four FETs 2 are arranged parallel to each other, and four Schottky diodes 3 are arranged parallel to each other. The order of the four units in this array is optional. As described later, this GaN-based semiconductor integrated circuit 1 can be made to function as a power conversion device.

Next, the unit consisting of one FET 2 and one Schottky diode 3 will be described. As seen in FIG. 2 which is a cross-sectional view along A-A' in FIG. 1 showing the device structure of the unit, the FET 2 and the Schottkey diode 3 are GaN-based semiconductor devices. The FET 2 comprises a channel layer 4, paired contact layers 5, 5 on either side of the channel layer 4, a source electrode S and a drain electrode D formed on the contact layers 5, 5, respectively, and a gate electrode G formed on the channel layer 4. The Schottky diode 3 has a Schottky junction 6 where metal is in contact with a semiconductor layer 9. The FET 2 and the Schottky diode 3 are formed on a single substrate 14 and thereby integrated at the same time.

The FET 2 may be either a normally-off FET in which a current flows between the source electrode S and the drain electrode D only when a voltage is applied to the gate electrode G, or a normally-on FET in which a current flows between the source electrode S and the drain electrode D even when no voltage is applied to the gate electrode G. It is to be noted that while, in the semiconductor integrated circuit described here, the Schottky diode 3 is integrated with the FET 2, it can be integrated with an IGBT, GTO or thyristor made from GaN-based semiconductors, in place of the FET 2.

The epitaxial structure of the Schottky diode 3 can be the same as that of the normally-off FET 2. For example, the normally-off FET can be formed by using, as the channel layer 4 in the FET 2, a combination of an electron supply layer and an electron transfer layer using a combination AlGaN/GaN (or AlGaN/AlN), and making the total thickness of the electron supply layer and electron transfer layer 10nm or smaller. The epitaxial structure using the combination AlGaN/GaN can be also used as the semiconductor layer 9 in the Schottky diode 3.

The Schottky diode 3 has two types of metal anodes which are both in contact with the GaN-based semiconductor layer 9, namely a first anode 10 and a second anode 11. Specifically, the first anode 10 is joined onto the GaN-based semiconductor layer 9 of a predetermined width to form a Schottky junction with a width smaller than the width of the GaN-based semiconductor layer 9. The second anode 11 is joined onto the GaN-based semiconductor layer 9 to form a Schottky junction in a region other than the region in which the first anode 10 is in contact with the GaN-based semiconductor layer 9, and is electrically connected with the first anode 10. The first anode 10 and the second anode 11 constitute a composite anode.

It is so arranged that the Schottky barrier formed between the second anode 11 and the GaN-based semiconductor layer 9 is higher than the Schottky barrier formed between the first anode 10 and the GaN-based semiconductor layer 9. The respective heights of the Schottky barriers are set by appropriately selecting the materials (metals) for the first and second anodes 10, 11. For example, for the first anode 10, a material that can form a Schottky barrier of about 0.3eV relative to the n-type GaN-based semiconductor layer 9, typically, any of Ti (titanium), Al (aluminium), Ta (tantalum), W (tungsten) and Ag (silver), or a silicide of any of these metals is used. For the second anode 11, a material that can form a Schottky barrier of about 1.0eV relative to the n-type GaN-based semiconductor layer 9, typically, any of Pt (platinum), Ni (nickel), Pd (palladium) and Au (gold) is used.

By forming the first and second anodes 10 and 11 using the materials (metals) as mentioned above, it is possible to make the Schottky barrier between the first anode 10 and the GaN-based semiconductor layer 9 low so that the on-state voltage across the Shottkey junction is 0.3 to 0.5 V, and make the Schottky barrier between the second anode 11 and the GaN-based semiconductor layer 9 higher than the Schottky barrier between the first anode 10 and the GaN-based semiconductor layer 9 so that the on-state voltage across the Shottkey junction is 1.0 to 1.5 V. Here, desirably, the electrical contact between the first anode 10 and the second anode 11 is made by arranging the second anode 10 of a greater width to cover the first anode 10 of a smaller width.

As described later, when the GaN-based semiconductor layer 9 is formed as a hetero-junction structure consisting of an n-type GaN layer and an AlGaN layer, two-dimensional electron gas produced near the hetero-junction interface acts as carriers to contribute much to increase of a forward current. Consequently, the Shottkey diode comes into on-state when the forward bias becomes about 0.1 to 0.3 V, which is lower compared with the case in which the AlGaN layer is not provided. In other words, the on-state voltage for the Shottkey diode 3 can be lowered to about 0.1V. By this, it is possible to further decrease the energy loss in the Shottkey junction region, and thereby decrease the amount of heat generated in the Shottkey junction, and hence, the amount of heat generated in the integrated circuit.

It is to be noted that the GaN-based semiconductor integrated circuit 1 according to the present invention is not limited to the circuit with only GaN-based semiconductor devices integrated on a single substrate. The integrated circuit can be so formed that GaN-based semiconductor devices and Si-based semiconductor devices are combined therein. In this case, it is possible to form GaN-based semiconductor devices and Si-based semiconductor devices on the same substrate and thereby integrate them at the same time.

### [Embodiment 1]

As described with reference to FIGS. 1 and 2, a GaN-based semiconductor integrated circuit 1 in embodiment 1 is so formed that two GaN-based semiconductor devices of different types, namely one FET 2 and one Schottky diode 3 form one unit (part surrounded by the dotted line in FIG. 2), and that four of such units are integrated. The size of the GaN-based semiconductor integrated circuit 1 having the plane structure shown in FIG. 1 is 10mm × 5mm, which about one tenth of the size of the Si-based semiconductor integrated circuit having about the same power capacity.

The FET 2 has a channel layer 4 consisting of a semiconductor layer (electron supply layer) 7 of Al_{0.2}Ga_{0.8}N of thickness 30nm and a semiconductor layer (electron transfer layer) 8 of GaN of thickness 400nm. Contact layers 5, 5 of n-type GaN on either side of the channel layer 4 are embedded in etched grooves formed in the channel layer 4 by etching. The contact layers 5, 5 are the regions for taking out carries flowing through the channel layer 4, through electrodes. A source electrode S and a drain electrode D are formed on the contact layers 5, 5, respectively, and a gate electrode G for controlling carriers flowing through the channel layer 4 is formed on the channel layer 4.

The Schottky diode 3 has a Schottky junction 6 where metal is in contact with a semiconductor layer. In this embodiment, the Schottky diode 3 includes, as a GaN-based semiconductor layer 9, an Al_{0.2}Ga_{0.8}N layer of a predetermined width D (6µm) formed on a GaN layer of thickness 400nm, and metal is arranged on this GaN-based semiconductor layer (Al_{0.2}Ga_{0.8}N layer) 9 to form a Schottky junction 6. It is to be noted that the Al_{0.2}Ga_{0.8}N layer as well as the GaN layer are shared by the Schottky diode 3 and the FET 2. Specifically, the Al_{0.2}Ga_{0.8}N layer forms the semiconductor layer 7 in the FET 2, and the GaN layer forms the semiconductor layer 8 in the FET 2.

The Schottky diode 3 has, as a first anode 10, a Ti/Al electrode joined onto the upper surface of the Al_{0.2}Ga_{0.8}N layer 9 to form a Schottky junction with a width smaller than the width D of the Al_{0.2}Ga_{0.8}N layer 9 (desirably, 0.3 to 2 µm, for example, 2µm). The Schottky diode 3 has further, as a second anode 11, a Pt/Au electrode joined onto the upper surface of the Al_{0.2}Ga_{0.8}N layer 9 to form a Schottky junction in a region other than the region covered by the Ti/Al electrode. The Ti/Al electrode (first anode 10) and the Pt/Au electrode (second anode 11) are electrically connected by the Pt/Au electrode (second anode 11) being arranged to cover the Ti/Al electrode (first anode 10). The first anode 10 and the second anode 11 constitute a composite anode.

In the Schottky junction 6 formed as described above, the Schottky barrier between Ti, the material (metal) forming the first anode 10, and the Al_{0.2}Ga_{0.8}N layer 9 is lower than the Schottky barrier between Pt, the material (metal) forming the second anode 11, and the Al_{0.2}Ga_{0.8}aN layer 9. The height of each Schottky barrier depends on the work function (Fermi level) of the metal that forms a Schottky junction with the Al_{0.2}Ga_{0.8}N layer 9.

The semiconductor layers 7, 9 of Al_{0.2}Ga_{0.8}N have a band gap greater than the semiconductor layer 8 of GaN has. Further, the semiconductor layers 7, 9 of Al_{0.2}Ga_{0.8}N form a hetero-junction with the semiconductor layer 8 of GaN, and the piezoresistance effect is produced at the hetero-junction interface. Due to this piezoresistance effect, two dimensional electron gas is produced in the semiconductor layer 8 having a smaller band gap, near the hetero-junction interface, and acts as carriers in the semiconductor layers 7, 9. Consequently, when the Schottky diode 3 is forward biased, a current flows across the Schottky junction 6 more easily, so that the on-state voltage for the first anode 10 and the on-state voltage for the second anode 11 further lower. Combined with the lowering of the on-state voltage for the Schottky diode 3, this makes it possible to provide a semiconductor integrated circuit for a large current which does not generate a large amount of heat and has a high withstand voltage.

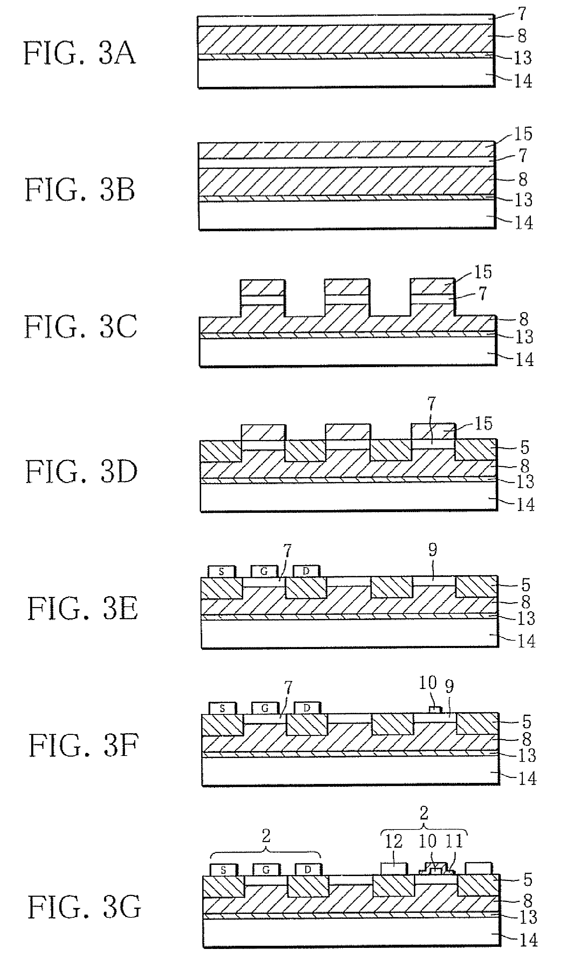

The GaN-based semiconductor circuit 1 having the above-described structure is produced as follows:
[I] Using ultrahigh vacuum apparatus having a growth chamber and a patterning chamber, an epitaxial wafer is made by the molecular beam epitaxial method, as follows: First, on a semi-insulating silicon substrate 14, an Al_{0.1}Ga_{0.9}N buffer layer 13 of thickness 5nm is formed at growth temperature 640°C using nitrogen in the form of free radical (7×10⁻³Pa), Al (1×10⁻⁵ Pa) and Ga (7×10⁻⁵Pa). Then, on the Al_{0.1}Ga_{0.9}N buffer layer 13, an undoped GaN layer (corresponding to the semiconductor layer 8) of thickness 400nm is formed at growth temperature 780°C using ammonia (7×10⁻³Pa) and Ga (7×10⁻⁵Pa). Then, on the undoped GaN layer, an undoped Al_{0.2}Ga_{0.8}N layer (corresponding to the semiconductor layer 7) of thickness 30nm is formed at growth temperature 850°C using ammonia (7×10⁻³Pa), Ga(7×10⁵Pa) and Al (1×10⁻⁵Pa). As a result, an epitaxial wafer having a layer structure shown in FIG. 3A is obtained.
[2] Next, using plasma CVD apparatus, an SiO₂ layer 15 is deposited on the epitaxial wafer as shown in FIG. 3B. Then, using photolithography and chemical etching, gate regions are masked and openings are formed at the places which are to become a source and a drain, and the place where a cathode of each Schottky diode 3 is to be formed. Then, as shown in FIG, 3C, within the openings, the semiconductor layers are etched by dry etching, with the etching depth of 100nm.
[3] Next, as shown in FIG. 3D, an Si-doped n-type GaN contact layer 5 is embedded in the openings formed in the semiconductor layers, using MOCVD apparatus, with the doping concentration of 1×10¹⁹ to 5×10²⁰ cm⁻³. After the contact layer 5 is embedded, the SiO₂ film 15 on the undoped Al_{0.2}Ga_{0.8}N layer (semiconductor layer 7) is removed using hydrofluoric acid.
[4] Then, as shown in FIG. 3E, by EB deposition, Ta silicide/Au electrodes of thickness 300nm/200nm are formed as a source electrode S and a drain electrode D of each FET 2, while a Pt/Au electrode of thickness 100nm/200nm is formed as a gate electrode G of each FET 2. Thus, each FET 2 is completed.
[5] Then, the electrodes of each Schottky diode 3 are formed. First, as shown in FIG. 3F, by normal EB deposition and liftoff technology, a Ti/Al electrode of thickness 100nm/300nm and width 2µm functioning as a first anode 10 is formed on the Al_{0.2}Ga_{0.8}N layer 9. Next, as shown in FIG. 3G, as a second anode 11 which forms a Schottky junction with the Al_{0.2}Ga_{0.8}N layer 9 and is directly connected with the Ti/Al electrode, a Pt/Au electrode of thickness 100nm/300nm is formed on the surface of the Al_{0.2}Ga_{0.8}N layer 9, in a region other than the region covered by the Ti/Al electrode.
[6] Last, as shown in FIG. 3G, a cathode 12 of a metal silicide which formes an ohmic junction with the contact layer 5 is formed. Thus, each Schottky diode 3 is completed. It may be so arranged that the cathode 12 is formed at the same time the source electrode S and drain electrode D of each FET 2 are formed. The GaN-based semiconductor integrated circuit 1 in this embodiment is completed by the process described above.

It was found that the withstand voltage of the Schottky diode 3 in the GaN semiconductor integrated circuit 1 thus produced was higher than 600V, and that the on-state voltage for the Schottky diode 3 was 0.1V, which is very low. When the Schottky diode 3 was in on-state, the voltage across the p-n junction never became higher than 0.5V. The withstand voltage of the FET 2 was also higher than 600V, and the FET 2 was able to operate at a high operating frequency of 0.5GHz.

The channel layer 4 of the FET 2 in the GaN-based semiconductor integrated circuit 1 in this embodiment consists of the semiconductor layer 7 and the semiconductor layer 8, and two dimensional electron gas is produced in the semiconductor layer 8, near the interface between the semiconductor layers 7 and 8. Hence, the FET 2 in the GaN-based semiconductor integrated circuit 1 in this embodiment functions as a normally-on FET in which a current flows between the source electrode S and the drain electrode D even when no voltage is applied to the gate electrode G. The FET 2 may, however, be formed as a normally-off FET in which a current flows between the source electrode S and the drain electrode D when a voltage is applied to the gate electrode G, by using, as the channel layer 4, a single GaN layer doped with p-type impurities.

By forming GaN-based Schottky diodes 3 and GaN-based FETs 2 on the same substrate using the same materials to have similar device structures like this, the production process can be simplified.

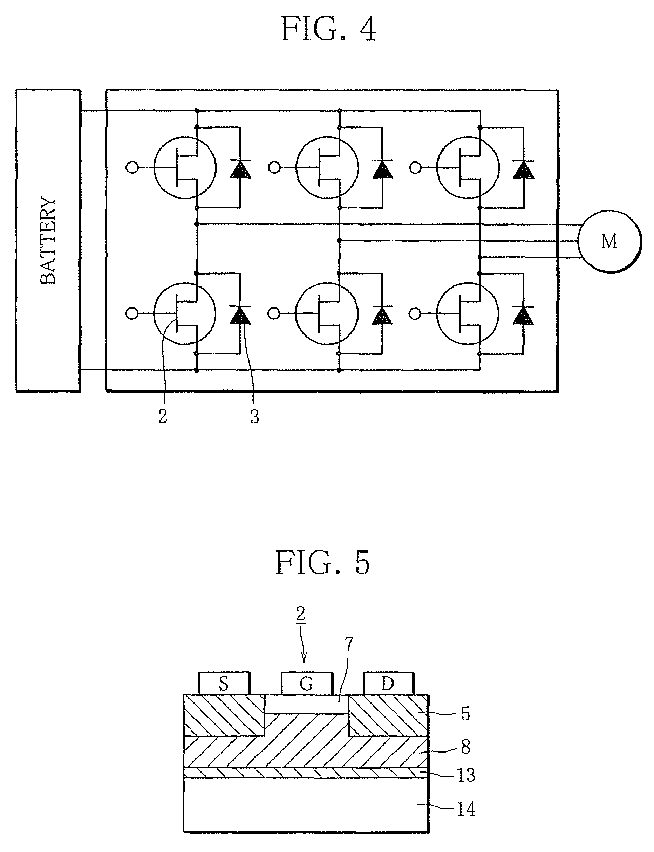

The GaN-based semiconductor integrated circuit 1 in this embodiment can be used in a power conversion device. For example, it can be used in an inverter circuit as shown in FIG. 4. In this case, one FET 2 and one Schottky diode 3 are connected in parallel, with the source electrode S of the FET 2 and the anode of the Schottky diode 3 connected to a common point and with the drain electrode D of the FET 2 and the cathode of the Schottky diode 3 connected to a common point, to form the inverter circuit shown in FIG. 4. It is to be noted that it is enough to use three of the four units consisting of one FET 2 and one Schottky diode 3, included in the GaN semiconductor integrated circuit 1 in this embodiment shown in FIG. 2. When used in the inverter circuit, the GaN-based semiconductor integrated circuit 1 in this embodiment functions as a power conversion device which converts single-phase power from a power supply into three-phase power consumed by a load M.

### [Embodiment 2]

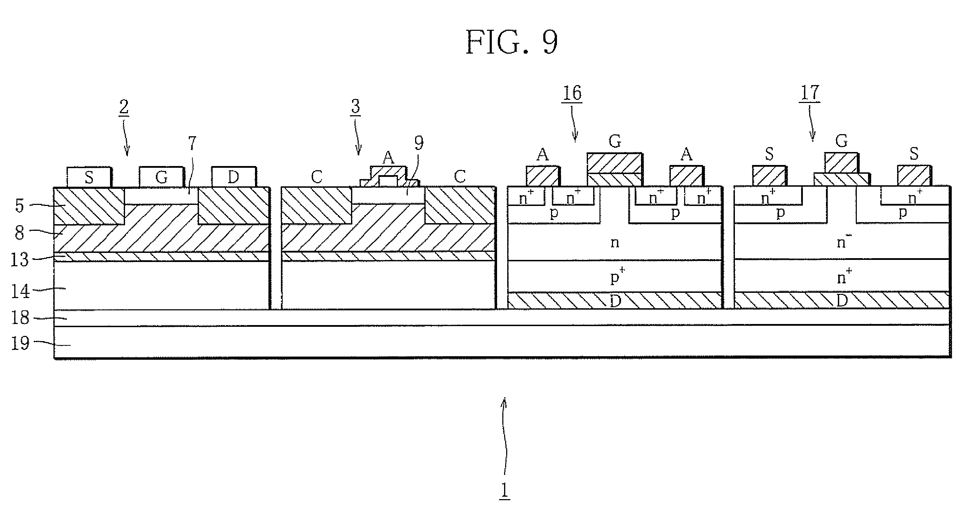

The GaN-based semiconductor integrated circuit according to the present invention can be also as follows: As shown in FIG. 9, this GaN-based semiconductor integrated circuit 1 is formed by integrating, on an Si substrate 19, a GaN-based semiconductor circuit 1 in embodiment 1, an Si-based IGBT 16 as commonly used, and an Si-based FET 17. In the Figure, reference signs A, C, S, D and G represent an anode, a cathode, a source electrode, a drain electrode, and a gate electrode, respectively.

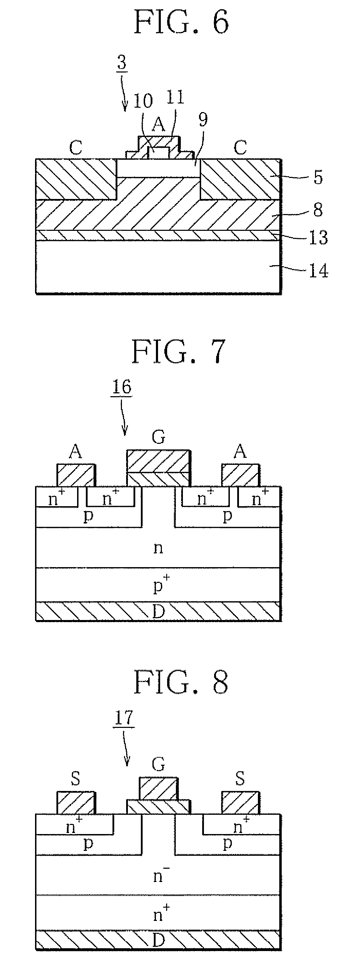

The GaN-based semiconductor integrated circuit in this embodiment is produced as follows:
[1] Using ultrahigh vacuum apparatus having a growth chamber and a patterning chamber, an epitaxial wafer is made by the molecular beam epitaxial method, as follows: First, on a semi-insulating Si substrate 19, an AlN layer 18 of thickness 50nm is formed at growth temperature 640°C using nitrogen in the form of free radical (7×10⁻³Pa) and Al (1×10⁻⁵Pa). Then, the Si substrate 19 is carried out from the growth chamber.
[2] Meanwhile, an FET 2 having a device structure shown in FIG. 5 and a Schottky diode 3 having a device structure shown in FIG. 6, which are the same as those included in the GaN semiconductor integrated circuit 1 in embodiment 1, and an Si-based IGBT 16 having a device structure shown in FIG. 7, which is commonly used, and an Si-based FET 17 having a device structure shown in FIG. 8 are prepared, separately. Then, these semiconductor devices 2, 3, 16 and 17 are placed on the AlN layer 18 formed on the Si substrate 19, as show in FIG. 9, and stuck together, using an araldate or epoxy insulting adhesive.

The GaN-based semiconductor integrated circuit produced by the process as described above can be used in a power conversion device, like the GaN-based semiconductor integrated circuit 1 in embodiment 1. Specifically, by connecting the electrodes in the GaN semiconductor integrated circuit as shown in FIG. 10, a power conversion device can be formed, as in the aforementioned case.

The invention thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A GaN-based semiconductor integrated circuit comprising a plurality of types of GaN-based semiconductor devices integrated on a substrate, wherein
one of the plurality of types of GaN-based semiconductor devices includes a Schottky diode,
the Schottky diode includes a GaN-based semiconductor layer, a first anode and a second anode, wherein the first anode is joined to the GaN-based semiconductor layer to form a Schottky junction with a width smaller than the width of the GaN-based semiconductor layer, the second anode is joined to the GaN-based semiconductor layer to form a Schottky junction in a region other than the region in which the first anode is in contact with the GaN-based semiconductor layer, and electrically connected with the first anode, and the Schottky barrier formed between the second anode and the GaN-based semiconductor layer is higher than the Schottky barrier formed between the first anode and the GaN-based semiconductor layer.

2. The GaN-based semiconductor integrated circuit according to claim 1, wherein
the plurality of types of GaN-based semiconductor devices include at least one of an FET, an IGBT, a GTO and a thyristor, as a GaN-based semiconductor device other than the Schottky diode.

3. The GaN-based semiconductor integrated circuit according to claim 1, wherein
the plurality of types of GaN-based semiconductor devices include the Schottky diode and an FET, wherein the FET has a device structure including a layer structure formed of almost the same semiconductor materials as the semiconductor materials forming the layer structure included in the device structure of the Schottky diode.

4. The GaN-based semiconductor integrated circuit according to claim 1 or 2, wherein
a semiconductor device other than a GaN-based semiconductor device is integrated with the plurality of types of GaN-based semiconductor devices, on the substrate.

5. A power conversion device incorporating a GaN-based semiconductor integrated circuit according to any of claims 1 to 3.

6. A power conversion device incorporating a GaN-based semiconductor integrated circuit according to claim 4.

7. The GaN-based semiconductor integrated circuit according to claim 1, wherein
the materials forming the first anode include any of metals Ti, Al, Ta, W and Ag or a silicide of any of these metals.

8. The GaN-based semiconductor integrated circuit according to claim 1, wherein
the materials forming the second anode includes any of metals Pt, Ni, Pd and Au.
